# FASCICULE DE BREVET EUROPEEN

(11) **EP 0 415 842 B1**
(45) Date de publication et mention de la délivrance du brevet: **13.04.1994**
(21) Numéro de dépôt: 90402376.9
(22) Date de dépôt: 28.08.1990
(51) Int. Cl.: G02F 1/136, H01L 27/12, H01L 21/84, H01L 29/784

(54) **Procédé de réalisation d'un écran d'affichage à matrice active et à structure inversée**
Verfahren zur Herstellung einer Anzeigetafel mit aktiver Matrix und invertierter Struktur
Method of making an inverted staggered active matrix for display panel

(30) Priorité: 29.08.1989 FR 8911331
(43) Date de publication de la demande: 06.03.1991
(73) Titulaire: FRANCE TELECOM, 75015 Paris (FR)
(72) Inventeur: Vinouze, Bruno, F-22710 Penvenan (FR); Chouan, Yannick, F-22700 Perros-Guirec (FR)
(74) Mandataire: Signore, Robert

(56) Documents cités:
- DE-A- 3 604 368
- GB-A- 2 077 039

## Description

La présente invention a pour objet un procédé de réalisation d'un écran d'affiche à matrice active et à structure inversée. Elle trouve une application privilégiée dans la réalisation d'écrans plats à cristaux liquides. Mais elle peut tout aussi bien être appliquée à d'autres matériaux que les cristaux liquides : électroluminescents, électrochromes, électrolytiques, etc...

Parmi les procédés les plus intéressants qu'on connaisse pour réaliser un écran d'affichage à matrice active se trouve le procédé dit à deux niveaux de masquage, tel que décrit dans la demande de brevet français FR-A-2 533 072. Dans un tel procédé, on réalise, sur une paroi transparente, des colonnes et une matrice de pavés définissant les futurs pixels, on dépose un empilement de trois couches respectivement en silicium amorphe hydrogéné, en isolant et en conducteur, on grave cet empilement en lignes chevauchant les colonnes et les pavés. Un transistor est ainsi formé à chaque chevauchement, avec, comme grille la partie conductrice de la ligne, comme drain le pavé et comme source la colonne.

La grille est donc placée au-dessus de la structure, dans une configuration que l'on peut qualifier de "normale".

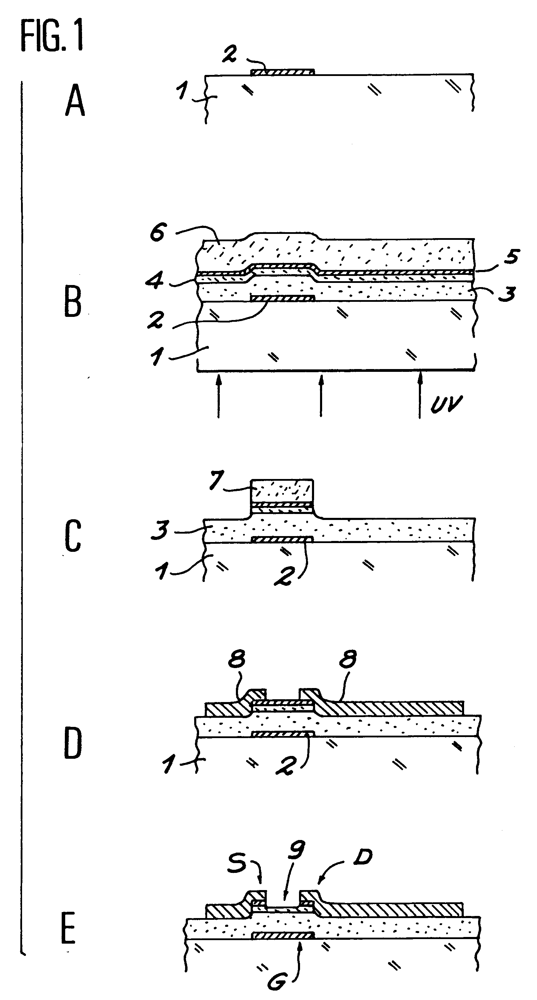

L'article de Yutaka MIYA et al. intitulé "Two-Mask Step-Inverted Staggered a-Si TFT-Addressed LCDs" publié dans SID (Society for Information Display) 89 DIGEST, pp 155 à 158 décrit un autre procédé, toujours à deux niveaux de masquage, mais conduisant à une structure inversée par rapport à la précédente, c'est-à-dire avec une grille située en-dessous de l'empilement de couches. Les principales étapes de ce procédé sont illustrées sur la figure 1.

Sur un support en verre 1, on dépose une couche conductrice, par exemple en chrome, que l'on grave sous forme de lignes parallèles 2 (partie A).

On dépose ensuite une couche 3 de nitrure de silicium, une couche 4 de silicium amorphe intrinsèque et une couche 5 de silicium amorphe dopé. Ces couches peuvent être déposées par PECVD ("plasma Enhanced Chemical Vapor Deposition"). Un photorésist 6 de type positif est ensuite déposée et l'ensemble est insolé par des ultraviolets à travers le substrat de verre (partie B). Dans cette opération d'insolation, les lignes conductrices constituent un masque opaque de sorte qu'après développement, il ne subsiste de photoresist 7 qu'au-dessus des lignes 2.

Ces lignes 7 de photorésist sont utilisées comme masque pour une gravure de la couche 5 de silicium amorphe dopé et de la couche 4 de silicium amorphe intrinsèque (partie C).

On dépose ensuite sur l'ensemble une couche conductrice 8 que l'on grave pour constituer des colonnes et des pavés venant chevaucher les lignes 2 (partie D) (la représentation est schématique). Prenant ces éléments comme masque, on grave la couche 5 de silicium amorphe dopé pour atteindre la couche 4 de silicium amorphe intrinsèque ce qui termine les transistors. Ceux-ci ont donc pour grille G la partie de la ligne 2 située sous la structure, pour source S l'extrémité du pavé et pour drain D une partie de la colonne (partie E).

Cette technique présente en fait deux inconvénients. Tout d'abord, l'insolation s'effectue à travers l'empilement forme par la couche 3 de nitrure de silicium, la couche 4 de silicium amorphe intrinsèque et la couche 5 de silicium amorphe dopé. Il faut donc limiter ces couches à une épaisseur très faible pour éviter une trop grande absorption, notamment pour la couche 4 de silicium amorphe intrinsèque, qui absorbe les ultraviolets. Mais la minceur de cette couche entraîne que les performances du transistor finalement constitué sont médiocres.

L'autre inconvénient est lié à ce que la couche métallique destinée à former les colonnes et les pavés n'est pas déposée sur une surface plane (parties C et D de la figure 1) mais sur une surface présentant des reliefs. Il s'ensuit des risques de défauts, notamment de coupures de colonnes.

La présente invention a justement pour but de remédier à ces inconvénients. A cette fin, elle propose un procédé qui est toujours à deux niveaux de masquage et conduit à une structure inversée, mais qui n'impose aucune contrainte sur l'épaisseur des couches semiconductrices et qui évite l'emploi d'une surface non plane pour recevoir les colonnes et pavés.

A cette fin, l'invention propose un procédé qui se distingue du précédent, essentiellement par le fait que l'on ne grave pas immédiatement la couche conductrice déposé sur le substrat, mais que l'on procède d'abord à la formation de l'empilement de couches. C'est tout cet empilement qui fait l'objet de la première gravure. Selon l'invention, on fait ensuite appel à un matériau photosensible négatif (et non pas positif comme dans l'art antérieur). L'insolation ne s'effectue pas à travers l'empilement de couche, puisque celui-ci a déjà été gravé, mais seulement à travers le verre, ce qui évite l'inconvénient lié à la minceur nécessaire de la couche semiconductrice. Par ailleurs, le caractère négatif du matériau renverse le résultat obtenu : le matériau subsiste entre les lignes d'empilement et assure ainsi la planéité de l'ensemble. C'est sur cette surface plane que seront déposés les colonnes et les pavés conducteurs qui formeront les sources et drains des transistors après une ultime gravure utilisant ces éléments comme masque.

De façon plus précise, la présente invention a donc pour objet un procédé de réalisation d'une paroi pour écran d'affichage à matrice active, caractérisé par le fait qu'il comprend les opérations suivantes :
- on dépose sur un substrat transparent un empilement de couches comprenant une première couche métallique, une couche isolante, une couche semiconductrice, une couche semiconductrice fortement dopée et une seconde couche conductrice,
- à travers un premier niveau de masquage, on effectue une première photogravure pour ne laisser subsister que des lignes de l'empilement,
- on recouvre l'ensemble de matériau photosensible de type négatif pour obtenir, entre les lignes d'empilement, une couche d'épaisseur égale à l'épaisseur dudit empilement,
- on insole l'ensemble à travers le substrat transparent, la première couche métallique des lignes d'empilement servant de masque opaque, et on enlève la résine non insolée située au-dessus des lignes d'empilement, ladite résine ne subsistant qu'entre les lignes d'empilement, et on planarise l'ensemble,
- on recuit cette résine,
- on dépose une couche conductrice transparente sur l'ensemble, on photograve cette couche pour constituer un second niveau de masquage, définissant des colonnes et des pavés munis d'un doigt parallèle aux colonnes, les colonnes et les doigts des pavés chevauchant les lignes d'empilement,
- on utilise les colonnes ainsi que les pavés et leurs doigts comme masque pour graver la seconde couche conductrice et la couche de semiconducteur dopé ce qui laisse subsister des transistors ayant comme grille la première couche métallique déposée sur le substrat, comme drain le doigt du pavé, comme source la colonne et comme canal la couche semiconductrice sous la zone gravée entre colonne et le doigt du pavé.

De préférence, l'isolant de la couche isolante est le nitrure de silicium (SiN) et le semiconducteur de la couche semiconductrice le silicium amorphe hydrogéné (aSiH).

De toute façon les caractéristiques et avantages de l'invention apparaîtront mieux à la lumière de la description qui va suivre. Cette description porte sur des exemples de réalisation, donnés à titre explicatif et nullement limitatif et elle se réfère à des dessins annexés sur lesquels :
- la figure 1, déjà décrite, illustre diverses étapes d'un procédé de fabrication selon l'art antérieur ;
- la figure 2 montre, en coupe, un empilement de couches sur un substrat de verre ;
- la figure 3 montre, en coupe, un ensemble de lignes après une première gravure ;
- la figure 4 montre, en coupe, le dépôt d'une couche de résine photosensible de type négatif avec insolation par l'arrière ;
- la figure 5 illustre une étape de planarisation ;
- la figure 6 montre, en coupe, le dépôt d'une couche conductrice transparente ;
- la figure 7 montre, en vue de dessus, la gravure des colonnes et des pavés ;
- la figure 8 montre, en vue de dessus, une variante de motif de gravure ;
- la figure 9 montre, en perspective, le détail de la zone de recouvrement d'une ligne d'empilement et d'une colonne, en coupe parallèle à une colonne ;
- la figure 10 montre une coupe le long d'une ligne après gravure des couches supérieures de l'empilement ; et,
- la figure 11 illustre une variante dans laquelle les colonnes sont recouvertes partiellement de colonnes métalliques.

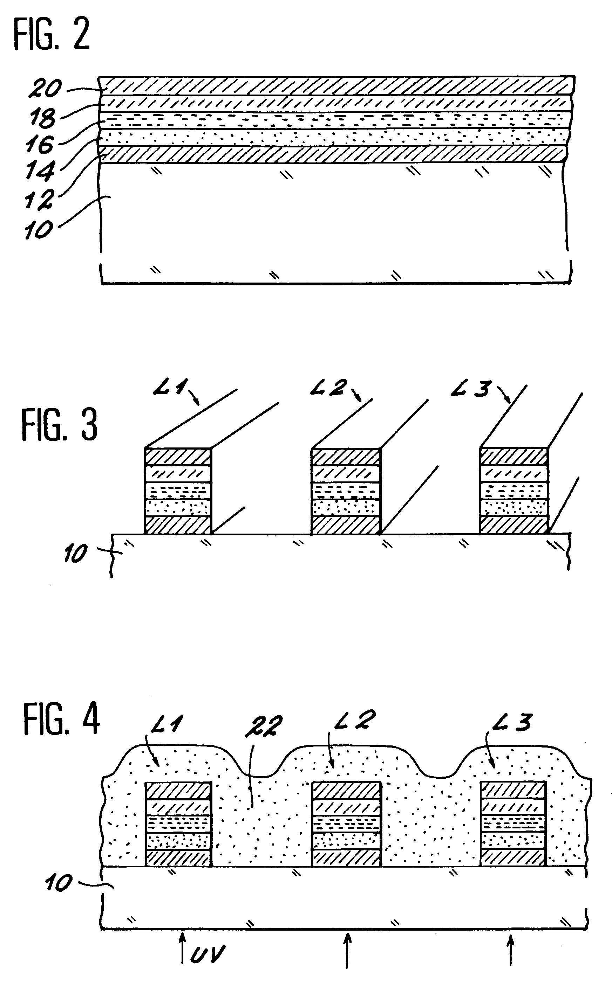

Sur la figure 2, on voit, en coupe, un substrat de verre 10, sur lequel sont déposées une couche métallique 12 (le métal étant par exemple le chrome, le tantale, le molybdène, le tungstène, etc...), une couche d'isolant 14, par exemple en nitrure de silicium, une couche semiconductrice 16, par exemple en silicium amorphe hydrogéné, une couche semiconductrice dopée n⁺ 18, par exemple en silicium et éventuellement une couche métallique 20.

Les couches 14, 16 et 18 peuvent être déposées par PECVD (Plasma Enhanced Chemical Vapor Deposition) et dans le même cycle.

L'épaisseur de ces couches peut être, à titre explicatif, de 200 à 300 nm pour la couche 12, de 300 nm pour la couche 14, de 50 nm pour la couche 16, de 100 nm pour la couche 18 et de 200 nm pour la couche 20, soit au total un empilement d'environ 1,2 à 1,3 µm.

Cet empilement est photogravé conformément à la figure 3 pour ne laisser que des lignes d'empilement L1, L2, L3, etc... Cette opération correspond au premier niveau de masquage et à la première gravure.

Selon la figure 4, le substrat portant ces lignes est recouvert de matériau photosensible 22 de type négatif, par exemple un polyimide négatif tel que le produit PI 2701 D de la Société du Pont de Nemours, ou le produit HTR 350 de la Société Merck. Ce polyimide est étendu à la tournette par exemple, avec une épaisseur égale à la hauteur de l'empilement, soit environ 1 µm.

Après centrifugation et séchage, on insole le polyimide. Pour cela, on l'expose aux ultraviolets à travers le substrat en verre. Les lignes de conducteur 12 et 20 agissent comme masques optiques. Le polyimide 22 étant de type négatif, seules les zones exposées aux ultraviolets sont réticulées, (c'est-à-dire, en pratique, les zones situées entre les lignes) alors que les zones masquées, (celles qui sont situées au-dessus des empilements) sont éliminées par le révélateur.

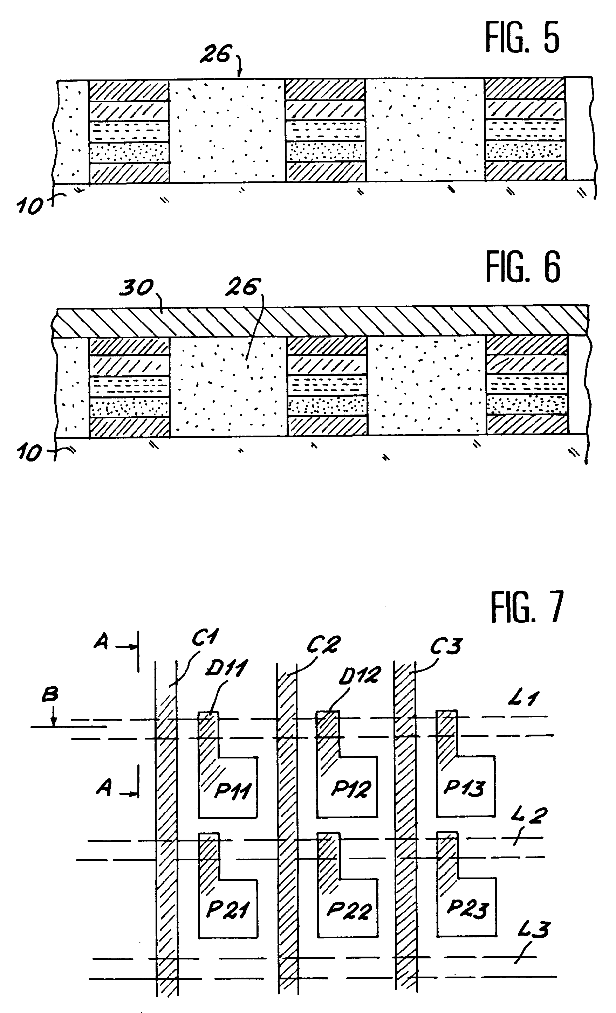

On obtient alors l'ensemble de la figure 5, sans qu'il y ait besoin de masque supplémentaire pour cette opération.

On recuit ensuite le polyimide pour le polymériser. La température maximale compatible avec les couches déjà déposées est d'environ 250°C. La surface supérieure 26 peut alors être planarisée.

On dépose ensuite (fig. 6) une couche conductrice transparente 30, par exemple en oxyde d'indium et d'étain.

Cette couche est ensuite photogravée pour délimiter des colonnes et des pavés rectangulaires correspondant aux futurs pixels de l'écran. Sur la figure 7, on voit ainsi des colonnes C1, C2, C3, ... et des pavés P11, P12, ... à proximité de la ligne L1, des pavés P21, P22, ..., à proximité de la ligne L2, etc. Chaque pavé rectangulaire est prolongé par un doigt, soit D11 pour le pavé P11, D12 pour la pavé P12, etc..., ce doigt chevauchant la ligne. La figure 7 montre, en vue de dessus, l'allure de ce deuxième niveau de masquage.

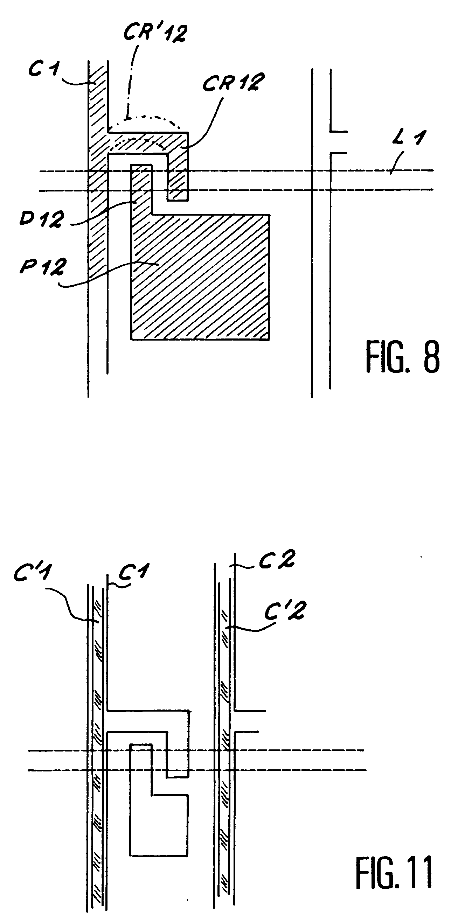

On peut aussi définir des segments supplémentaires appelés crosses tels que CR12, ... représentés que la figure 8, qui partent de la colonne, viennent contourner l'extrémité du doigt (D12) et viennent chevaucher la ligne (L1), de telle sorte que le doigt relié au pavé soit intercalé entre la colonne et la crosse.

On peut aussi adopter une forme arrondie CR'12 tel le que représentée en tirets sur la figure 8.

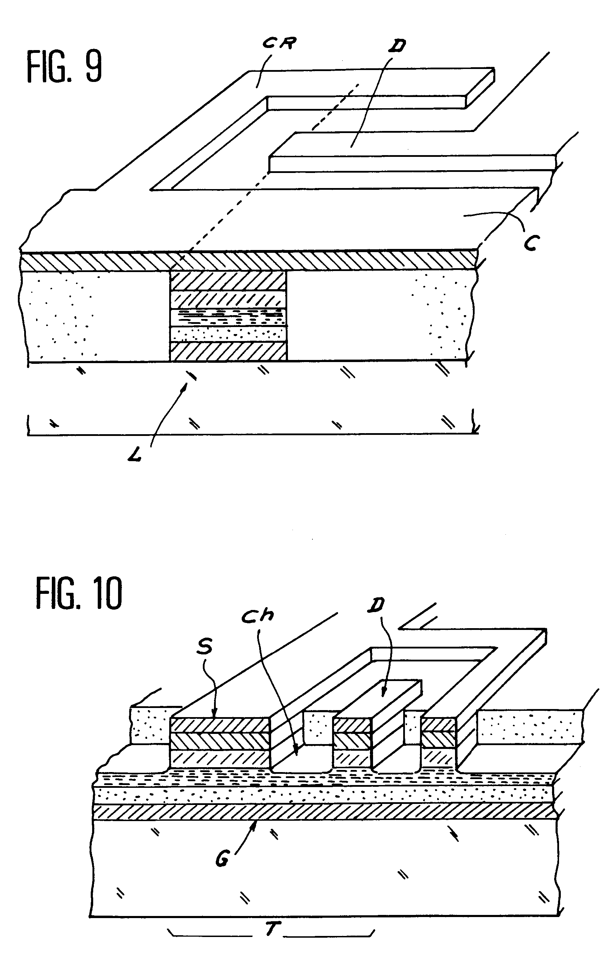

La figure 9 montre, en perspective, la zone de chevauchement d'une ligne L avec une colonne C, une crosse CR, un doigt D.

A titre explicatif, les dimensions peuvent être les suivantes : largeur d'une colonne : 20 µm, largeur d'un doigt : 8 µm, largeur d'une crosse : 8 µm, intervalles entre doigt et colonne et doigt et crosse : 8 µm.

Il reste à graver le métal supérieur 20 et le silicium dopé 18 pour définir le canal du transistor. Cette gravure est effectuée à travers le réseau de colonnes de doigts et éventuellement de crosses. Le résultat est représenté en perspective sur la figure 10. Dans cette gravure, le polyimide subsiste.

On obtient ainsi un transistor T avec comme drain D le doigt, comme source S la colonne, comme grille G la ligne et comme canal Ch la zone située entre colonne et droigt. Dans la variante à crosse illustrée sur la figure 10, on obtient en fait, un double transistor avec un drain en commun.

Une couche de passivation, par exemple en nitrure de silicium, recouvrira éventuellement l'ensemble obtenu.

Dans une autre variante avantageuse illustrée sur la figure 11, on peut déposer sur chaque colonne transparente conductrice C1, C2, ..., une colonne métallique très conductrice C'1, C'2, ... En effet, le matériau transparent conducteur tel que l'oxyde d'étain et d'indium, est assez résistif (10 ohms par carré environ), ce qui limite la taille des écrans à une dizaine de centimètres de côté. L'utilisation de colonnes métalliques supplémentaires permettra de s'affranchir de cet effet tout en assurant une redondance en cas de coupure de colonne.

Pour éviter les problèmes d'alignement, la largeur des colonnes métalliques sera avantageusement plus faible que celle des colonnes en ITO.

Naturellement, cette variante nécessite un troisième niveau de masquage.

Les opérations qui précédent permettent de réaliser l'une des deux parois d'un écran d'affichage. Il reste à réaliser l'autre, ce qui ne présente aucune difficulté puisque cette paroi n'est qu'une simple plaque de verre recouverte d'une contre-électrode. Les deux parois sont alors mises en regard l'une de l'autre et séparées par une câle d'épaisseur. Le cristal liquide est ensuite introduit dans le volume ainsi délimité.

Après cette description, on voit que le procédé de l'invention présente de nombreux avantages, notamment de simplicité (deux niveaux de masquage), de fiabilité (planarisation de la surface intermédiaire évitant les coupures). Il permet de bénéficier pleinement des avantages propres à la structure inversée. On sait, à cet égard, que dans la technique PECVD, la qualité de la couche de silicium amorphe est influencée par la nature du support. Dans la structure normale (grille au-dessus), le silicium est déposé sur du verre et de l'ITO et il s'ensuit que les mobilités obtenues sont faibles et de l'ordre de 0,2 cm²/Vs. En revanche, dans la structure inversée, le silicium est déposé sur une couche de nitrure de silicium ce qui est beaucoup plus favorable. Les demandeurs ont ainsi pu mesurer des mobilités plus de deux fois plus élevées (environ 0,5 cm²/Vs).

En outre, la structure inversée permet d'employer une épaisseur de semiconducteur dopé plus importante (par exemple 100 nm au lieu de 30) ce qui améliore les contacts source et drain du transistor.

Enfin, la couche métallique de grille isole les matériaux "nobles" (nitrure de silicium, silicium amorphe et silicium dopé) du verre. Un verre flotté du type sodocalcique, donc peu cher, pourra convenir, ce qui n'est pas le cas avec une structure "normale" grille dessus.

## Revendications

1. Procédé de réalisation d'une paroi pour écran d'affichage à matrice active, caractérisé par le fait qu'il comprend les opérations suivantes :
- on dépose sur un substrat transparent (10) un empilement de couches comprenant une première couche métallique (12), une couche isolante (14), une couche semiconductrice (16), une couche semiconductrice fortement dopée (18)et une seconde couche conductrice (20),
- à travers un premier niveau de masquage, on effectue une première photogravure pour ne laisser subsister que des lignes de l'empilement (L1, L2, L3, ...),
- on recouvre le substrat et les lignes de matériau photosensible de type négatif (22) pour obtenir, entre les lignes d'empilement, une couche d'épaisseur égale à l'épaisseur dudit empilement,
- on insole l'ensemble à travers le substrat transparent (10), la première couche métallique (12) des lignes d'empilement servant de masque opaque, on enlève la résine non insolée située au-dessus des lignes a'empilement, ladite résine ne subsistant qu'entre les lignes d'empilement (L1, L2, ...), on planarise ainsi l'ensemble, puis on recuit la résine,
- on dépose une couche conductrice transparente (30) sur l'ensemble, on photograve cette couche pour constituer un second niveau de masquage, définissant des colonnes et des pavés munis d'un doigt parallèle aux colonnes, les colonnes et les doigts des pavés chevauchant les lignes d'empilement (L1, L2, L3, ...),
- on utilise les colonnes ainsi que les pavés et leurs doigts comme masque pour graver la seconde couche conductrice (20) et la couche de semiconducteur dopé (18), ce qui laisse subsister des transistors (T) ayant comme grille (G) la première couche métallique (12) déposée sur le substrat, comme drain (D) le doigt du pavé, comme source (S) la colonne et comme canal (Ch) la couche semiconductrice (16) sous la zone gravée entre la colonne et le doigt du pavé.

2. Procédé selon la revendication 1, caractérisé par le fait que le métal de la première couche conductrice (12) est sélectionné dans le groupe consistant en : le chrome, le tantale, le molybdène, le tungstène.

3. Procédé selon la revendication 1, caractérisé par le fait que l'isolant de la couche isolante (14) est le nitrure de silicium (SiN) et que le semiconducteur de la couche semiconductrice (16) est le silicium amorphe hydrogéné (aSiH).

4. Procédé selon la revendication 1, caractérisé par le fait que la couche conductrice transparente (30) est en oxyde d'indium et d'étain.

5. Procédé selon la revendication 1, caractérisé par le fait que l'on dépose finalement sur l'ensemble une couche de passivation.

6. Procédé selon la revendication 1, caractérisé par le fait que l'on dépose sur les colonnes en matériau conducteur transparent, à travers un troisième masque et par une troisième gravure, des colonnes (C'1, C'2, ...) de métal de largeur inférieure à celle des colonnes (C1, C2, ...) en matériau conducteur transparent.

7. Procédé selon la revendication 1, caractérisé par le fait que le second masque et la seconde gravure définissent en outre un segment en forme de crosse (CR12, ...) partant de la colonne (C1, C2, ...), contournant l'extrémité du doigt (D11, ...) du pavé et venant chevaucher la ligne (L1, L2, ...) de telle sorte qu'après gravure deux transistors soient constitués pour chaque pixel, un de chaque côté du doigt, avec un drain commun constitué par le doigt du pavé.

## Patentansprüche

1. Verfahren zur Herstellung einer Anzeigetafel mit aktiver Matrix, dadurch gekennzeichnet, daß es die folgenden Operationen aufweist:
- man bringt einen Stapel von Schichten auf ein transparentes Substrat (10) auf, umfassend eine metallische Schicht (12), eine isolierende Schicht (14), eine Halbleiterschicht (16), eine stark dotierte Halbleiterschicht (18) und eine zweite leitende Schicht (20),
- man führt eine erste Photogravierung aus durch eine erste Maskierungsebene, so daß nur noch Stapelzeilen (L1, L2, L3, ...) vorhanden sind,
- man bedeckt das Substrats und die Zeilen mit einem photosensiblen Material des negativen Typs (22), um zwischen den Stapelzeilen eine Schicht gleicher Dicke zu erhalten wie die Dicke des genannten Stapels,
- man belichtet den Aufbau durch ein transparentes Substrat (10), wobei die erste metallische Schicht 12 der Stapelzeilen als lichtundurchlässige Maske dient, man entfernt das nichtbelichtete, über den Stapelzeilen befindliche Harz, wobei das Harz nur zwischen den Stapelzeilen (L1, L2, L3, ...) weiter vorhanden ist, man ebnet somit den Aufbau, dann tempert man das Harz,
- man bringt eine transparente, leitende Schicht (30) auf dem Aufbau auf, man photograviert diese Schicht, um eine zweite Maskierungsebene zu bilden, Spalten bildend und Platten, mit einem parallel zu den Spalten verlaufenden Finger versehen, wobei die Spalten und die Finger der Platten sich überschneiden mit den Stapelzeilen (L1,L2, L3, ...),
- man benutzt die Spalten sowie die Platten und ihre Finger als Maske, um die zweite leitende Schicht (20) zu ätzen und die dotierte Halbleiterschicht (18), was Transistoren (T) bestehen läßt, die die erste metallische Schicht (12), aufgebracht auf das Substrat, als Gate (G) haben, den Finger der Platte als Drain (D), die Spalte als Source (S) und als Kanal (Ch) die Halbleiterschicht (16) unter der geätzten Zone zwischen der Spalte und dem Finger der Platte.

2. Verfahren nach Anspruch 1, dadurch gekennzeichnet, daß das Metall der ersten leitenden Schicht (12) ausgewählt wird aus der Gruppe, die besteht aus: dem Chrom, dem Tantal, dem Molybdän, dem Tungsten.

3. Verfahren nach Anspruch 1, dadurch gekennzeichnet, daß der Isolator der isolierenden Schicht (14) das Siliziumnitrid (SiN) ist, und daß der Halbleiter der Halbleiterschicht (16) das hydrierte amorphe Silizium (aSiH) ist.

4. Verfahren nach Anspruch 1, dadurch gekennzeichnet, daß die transparente leitende Schicht (30) aus Indium- und Zinnoxid ist.

5. Verfahren nach Anspruch 1, dadurch gekennzeichnet, daß man abschließend auf dem Aufbau eine Passivierungsschicht aufbringt.

6. Verfahren nach Anspruch 1, dadurch gekennzeichnet, daß man auf den Spalten aus transparentem Leitermaterial, durch eine dritte Maske und mittels einer dritten Ätzung, Spalten (C'1, C'2, ...) aus Metall aufbringt, die eine geringere Breite aufweisen als die Spalten (C1, C2, ...) aus transparentem Leitermaterial.

7. Verfahren nach Anspruch 1, dadurch gekennzeichnet, daß die zweite Maske und die zweite Ätzung außerdem ein hakenförmiges Segment (CR12, ...) definieren, ausgehend von der Spalte (C1, C2, ...), um das Ende des Fingers (D11, ...) der Platte herum verlaufend und die Zeile (L1, L2, ...) überschneidend, so daß sich nach der Ätzung zwei Transistoren für jedes Pixel bilden, einer auf jeder Seite des Fingers, mit einem gemeinsamen Drain, gebildet durch den Finger der Platte.

## Claims

1. Process for producing a wall for an active matrix display screen, characterized in that it comprises depositing on a transparent substrate (10) a stack of layers constituted by a first metallic layer (12), an insulating layer (14), a semiconducting layer (16), a highly doped semiconducting layer (18) and a second conducting layer (20), a first photoetching takes place through a first masking level so as to only leave behind the stack lines (L1, L2, L3, etc), the substrate and lines are covered with negative photosensitive material (22) in order to obtain, between the stack lines, a layer having a thickness equal to that of said stack, the assembly is irradiated through the transparent substrate (10), the first metallic layer (12) of the stack rows serving as an opaque mask, the non-irradiated resin located above the stack rows is removed, said resin only being left between the stack rows (L1, L2, etc.), followed by the planarization of the assembly and the annealing of the resin, a transparent conductive layer (30) is deposited on the assembly and said layer undergoes photo-etching to form a second masking level, defining columns and blocks provided with a finger parallel to the columns, the columns and block fingers overlapping the stack rows (L1, L2, L3 etc.) and the columns and blocks, as well as the fingers of the latter are used as a mask for etching the second conductive layer (20) and the doped semiconducting layer (18), which leaves transistors (T) having as the gate (G) the first metallic layer (12) deposited on the substrate, as the drain (D) the block finger, as the source (S) the column and as the channel (Ch) the semiconducting layer (16) beneath the etched zone between the column and the block finger.

2. Process according to claim 1, characterized in that the metal of the first conductive layer (12) is chosen from the group consisting of chromium, tantalum, solybdenum and tungsten.

3. Process according to claim 1, characterized in that the insulant of the insulating layer (14) is silicon nitride (SiN) and that the semiconductor of the semi-conducting layer (16) is amorphous hydrogenated silicon (aSiH).

4. Process according to claim 1, characterized in that the transparent conducting layer (30) is of indium-tin oxide.

5. Process according to claim 1, characterized in that a passivating layer is deposited on the assembly.

6. Process according to claim 1, characterized in that on the transparent conductive material columns is deposited, through a third mask and by a third etching, columns (C'1, C'2 etc.) of metal with a width smaller than that of the columns (C1, C2, etc) of transparent conductive material.

7. Process according to claim 1, characterized in that the second mask and the second etching also define a crook-shaped segment (CR12, etc) emanating from the column (C1, C2, etc), passing round the end of the finger (D11, etc) of the block and overlapping the row (L1, L2 etc.) in such a way that after etching two transistors are formed for each pixel, one on either side of the finger and having a common drain constituted by the finger of the block.
